# EUROPÄISCHE PATENTSCHRIFT

(11) **EP 0 542 069 B1**
(45) Veröffentlichungstag und Bekanntmachung des Hinweises auf die Patenterteilung: **28.05.1997**
(21) Anmeldenummer: 92118669.8
(22) Anmeldetag: 31.10.1992
(51) Int. Cl.: H01L 27/06, G01R 31/26

(54) **Halbleiteranordnung**
Semi-conductor device
Dispositif à semi-conducteur

(30) Priorität: 12.11.1991 DE 4137084
(43) Veröffentlichungstag der Anmeldung: 19.05.1993
(73) Patentinhaber: TEMIC TELEFUNKEN microelectronic GmbH, 74072 Heilbronn (DE)
(72) Erfinder: Sapotta, Hans, Dr., W-7100 Heilbronn (DE); Schall, Heinrich, W-7128 Lauffen (DE); Stockinger, Herbert, W-6953 Gundelsheim (DE)
(74) Vertreter: Maute, Hans-Jürgen, Dipl.-Ing.

(56) Entgegenhaltungen:
- US-A- 4 051 504
- US-A- 4 127 859
- PATENT ABSTRACTS OF JAPAN vol. 003, no. 124 (E-144)17. Oktober 1979 & JP-A-54 100 672
- Ruge, Halbleiter-Technologie, Springer Verlag, Berlin, 1984, Seiten 30,31

## Beschreibung

Das sogenannte "Burst-Rauschen" von Bipolartransistoren - statistisch auftretende Anstiege des Kollektorstroms - entsteht durch Kristallfehler im Substratmaterial der Halbleiteranordnung; diese Kristallfehler werden als Stapelfehler (linienförmigen Defekte des Kristallgitters) in die Epitaxieschichten der Halbleiteranordnung fortgesetzt und verursachen bei Bipolartransistoren lokale Feldstärkemaxima in der Raumladungszone des Emitter-Basis-Bereichs oder des Basis-Kollektor-Bereichs. Die Feldstärkemaxima brechen nach chaotischen Regeln durch, woraus unkorrelierte Anstiege des Kollektorstroms resultieren - die sogenannten "Rausch-Bursts". Durch das Burst-Rauschen wird vielfach die Wirkungsweise von Bipolartransistoren beeinträchtigt: beispielsweise hat das Burst-Rauschen beim Oszillator-Transistor eines FM-Mischers eine Schwankung der Oszillatorfrequenz zur Folge, die über den ZF-Verstärker und den Diskriminator auf den NF-Kanal und damit auf den Lautsprecher gegeben wird. Daneben stellt das Burst-Rauschen insbesondere bei Verstärkertransistoren zur Verstärkung extrem kleiner Spannungen wie beispielsweise Mikrofonverstärkern und bei Transistoren für den Niederfrequenzbereich ein großes Problem dar. Halbleiteranordnungen bzw. integrierte Schaltkreise (ICs) mit vom Burst-Rauschen betroffenen Transistoren müssen daher durch Prüfmessungen ausgesondert werden - beispielsweise bei FM-Mischern über eine Messung des Störabstands des Oszillators oder des ZF-Signals. Da das Burst-Rauschen jedoch völlig unregelmäßig auftritt, benötigt man für eine aussagekräftige Messung eine lange Meßzeit, wodurch die Herstellungskosten der Halbleiteranordnung bzw. des integrierten Schaltkreises stark erhöht werden.

Der Erfindung liegt die Aufgabe zugrunde, eine Halbleiteranordnung gemäß dem Oberbegriff des Patentanspruchs 1 anzugeben, die eine einfache Selektion von Halbleiteranordnungen mit Burst-Rauschen verursachenden Transistoren ermöglicht.
Diese Aufgabe wird erfindungsgemäß durch die Merkmale im Kennzeichen des Patentanspruchs 1 gelöst.
Vorteilhafte Weiterbildungen der Erfindung ergeben sich aus den Unteransprüchen.

JP-A-54 100 672 zeigt eine Anordnung mit Bipolartransistoren und Zenerdioden.

Erfindungsgemäß ist in Halbleiteranordnungen mit Bipolartransistoren, bei denen Burst-Rauschen auftreten kann bzw. die für das Auftreten des Burst-Rauschens disponiert sind, für jeden derartigen Bipolartransistor eine zusätzliche, als "Meßelement" fungierende Zenerdiode vorgesehen, die für die eigentliche Funktionsweise der Halbleiteranordnung bzw. der integrierten Schaltung nicht erforderlich ist. Diese Zenerdiode dient dadurch als Indikator für Kristallfehler und damit für Burst-Rausch-Effekte, daß die Abweichung der Durchbruchspannung der Zenerdiode vom technologisch vorgegebenen Wert gemessen und ausgewertet wird.
Die das Burst-Rauschen verursachenden Kristallfehler setzen sich in Linien (als linienförmige Defekte des Kristallgitters) durch die Schichten der Halbleiteranordnung fort; demnach wird sich ein Kristalldefekt in der aktiven Zone bzw. im Basisgebiet eines Bipolartransistors auch in die Umgebung des Bipolartransistors fortsetzen. Die Zenerdiode wird in der Halbleiteranordnung in der Nähe dieses Bipolartransistors angeordnet und umschließt diesen vollständig (bsp. ringförmig), so daß ihre Halbleitergebeite (Katode und Anode) ebenfalls von den Kristalldefekten (linienförmigen Defekten des Kristallgitters) betroffen sind. Durch die linienförmige Defekte des Kristallgitters wird folglich die - von der Dotierungskonzentration in der Halbleiteranordnung abhängige - Durchbruchspannung der Zenerdiode bei sehr kleinen Stromstärken reduziert, da das lokale Feldstärkemaximum zuerst beim Kristalldefekt durchbricht. Über eine Messung der Durchbruchspannung der Zenerdioden bei sehr kleinen Stromstärken können daher - die zu den Zenerdioden benachbarten - Transistoren mit Burst-Rauschen sehr einfach erkannt und die entsprechenden (fehlerhaften) Halbleiteranordnungen - bei denen die Durchbruchspannung der Zenerdiode signifikant verändert ist - ausselektiert werden.
Die Messung der Durchbruchspannung der Zenerdiode kann mit einer sehr einfachen Meßanordnung erfolgen und benötigt nur eine minimale Meßzeit. Da die Prüfmessung vorteilhafterweise bereits auf dem Silizium-Halbleiterkörper durchgeführt wird, können fehlerhafte bzw. fehleranfällige Halbleiteranordnungen frühzeitig ausselektiert werden - weitere Verarbeitungsschritte entfallen somit.

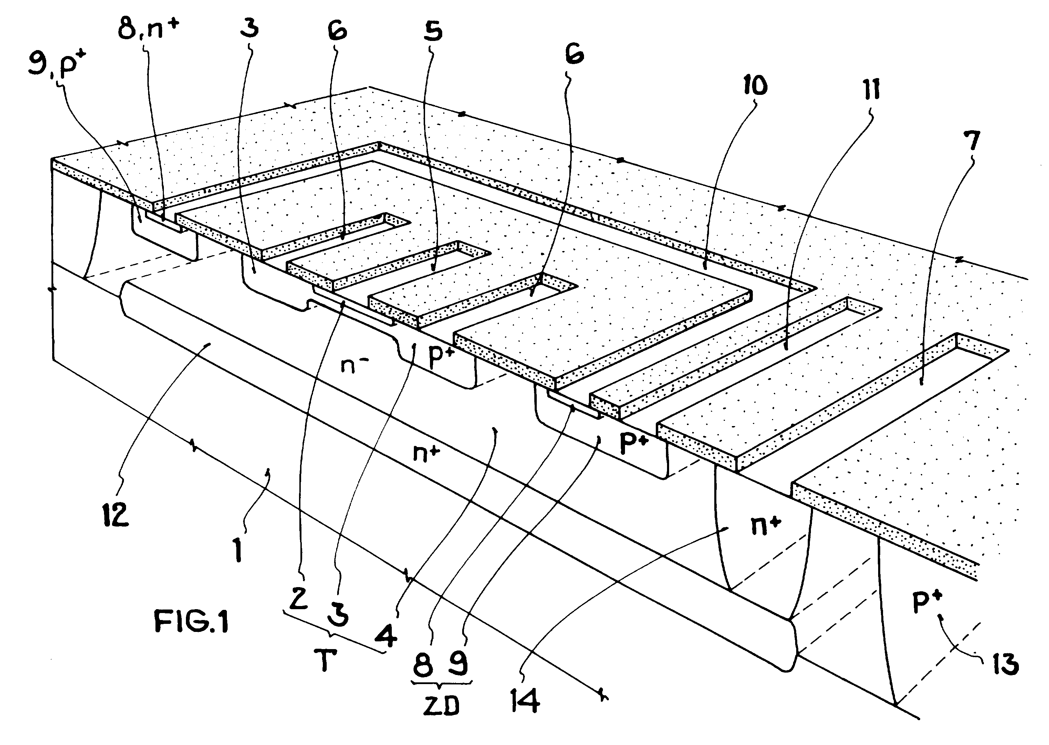

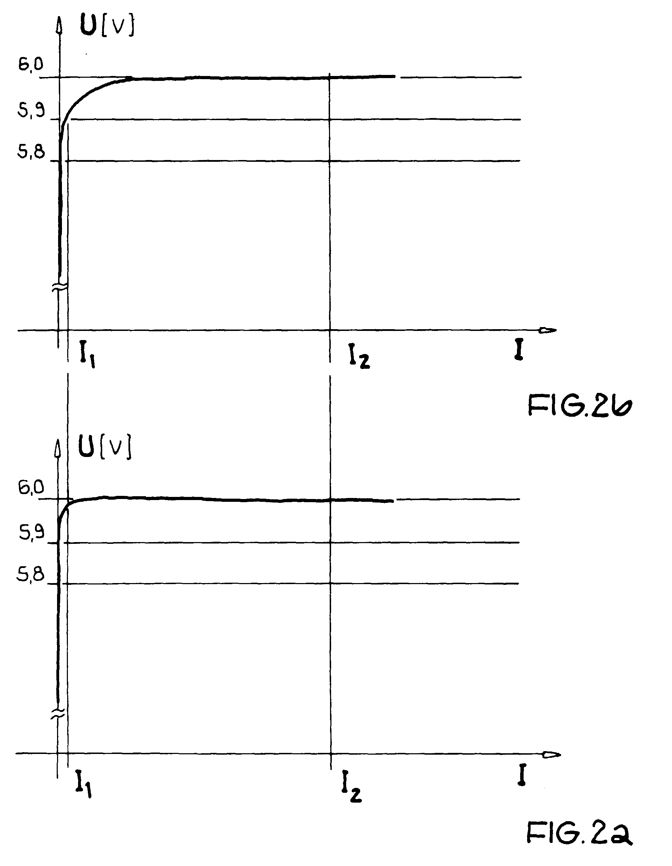

Die Erfindung soll weiterhin anhand der Figuren 1 und 2 näher erläutert werden.
Die Figur 1 zeigt die perspektivische Schnittdarstellung einer Halbleiteranordnung mit einem Bipolartransistor in Kollektor-Grundschaltung, die beispielsweise in Oszillatoren üblich ist. In der Figur 2 sind die Spannungs-Strom-Diagramme für eine Zenerdiode mit Kristalldefekten (Fig. 2a) und ohne Kristalldefekte (Fig. 2b) dargestellt.

Gemäß der Figur 1 besteht der Bipolartransistor T aus dem Basisgebiet 3 dem Emittergebiet 2 und dem Kollektorgebiet 4, die in den Halbleiterkörper 1 (das Substrat) der Halbleiteranordnung eindiffundiert werden, und die die Anschlüsse 6, 5 und 7 besitzen. Zur Isolation gegenüber benachbarten Bauelementen der Halbleiteranordnung dient die p⁺-Separationszone 13; desweiteren ist im Substrat 1 der Halbleiteranordnung eine hochdotierte vergrabene n⁺-Schicht 12 vorgesehen, die als niederohmiger Kollektoranschluß fungiert.
Im Bereich des Kollektoranschlußgebiets 14 des Transistors T ist eine Zenerdiode ZD mit den Halbleitergebieten 8 (Kathode) und 9 (Anode) vorgesehen, wobei die Zenerdiode ZD im wesentlichen ringförmig um den Bipolartransistor T angeordnet ist; die Halbleitergebiete 8 (Kathode) und 9 (Anode) der Zenerdiode ZD werden gleichzeitig mit dem Basisgebiet 3 und dem Emittergebiet 2 des Bipolartransistors T in das Substrat 1 eindiffundiert und besitzen die Anschlüsse 10 (Kathoden-Anschluß) und 11 (Anoden-Anschluß).

Anhand der Figur 2 wird die Wirkungsweise der Zenerdiode als Meßelement in der Halbleiteranordnung erläutert.
Bei einem defektfreien Halbleitermaterial und damit burstrausch-freiem Bipolartransistor bricht die Zenerdiode bei der im wesentlichen von der Dotierungskonzentration des Halbleitermaterials vorgegebenen Durchbruchspannung durch - dies ist in der Figur 2a im U-I-Diagramm für den Fall einer Durchbruchspannung von beispielsweise 6 V dargestellt.
Bei einem Burstrauschen verursachenden Kristalldefekt (linienförmiger Defekt des Kristallgitters) in der aktiven Zone bzw. im Basisgebiet eines Bipolartransistors wird dieser auch in die Halbleitergebiete der Zenerdiode fortgeführt; dadurch ergibt sich eine lokal erhöhte Feldstärke und damit auch eine lokal verminderte Durchbruchspannung. Dies ist im U-I-Diagramm der Figur 2b dargestellt: der Durchbruch der Zenerdiode beginnt bereits bei beispielsweise 5,9 V und geht erst bei größeren Stromstärken in den "normalen" Verlauf der Figur 2a über.
Durch eine Messung der Durchbruchspannung bei kleinen Stromstärken I₁ kann demnach zwischen den beiden geschilderten Fällen unterschieden werden; bei einer entsprechenden Auswertung der Meßergebnisse können folglich Halbleiteranordnungen mit Kristalldefekten in der aktiven Zone eines Bipolartransistors erkannt und ausgesondert werden. Optional kann darüber hinaus eine zusätzliche Messung der Durchbruchspannung bei einer größeren Stromstärke I₂ durchgeführt werden, um die Zuverlässigkeit der als meßelement ausgebildeten-Zenerdioden zu verifizieren.

In Halbleiteranordnungen, bei denen am Kollektor des Transistors kritische Wechselspannungen auftreten können, ist es vorteilhaft, die Zenerdiode im Separationsgebiet anzuordnen; die Zenerdiode kann dabei entweder zwischen der Separationszone und dem Emittergebiet oder zwischen einer vergrabenen Schicht ("buried layer") und der Separationszone gebildet werden.

## Patentansprüche

1. Halbleiteranordnung mit mindestens einem Bipolartransistor (T) und einer Zenerdiode (ZD), die in einen gemeinsamen Halbleiterkörper (1) eingebracht sind, dadurch gekennzeichnet, daß jeweils eine Zenerdiode (ZD), welche als Meßelement ausgebildet ist, einen Bipolartransistor (T), bei dem in der Raumladungszone des Basisgebiets (3) aufgrund von linienförmigen Defekten des Kristallgitters die Funktionsweise des Bipolartransistors beeinträchtigende, lokale Erhöhungen der elektrischen Feldstärke auftreten können, ganz umschließt, so daß sich die linienförmigen Defekte des Kristallgitters im Basisgebiet (3) dieses Bipolartransistors (T) in die Halbleitergebiete (8, 9) der Zenerdiode (ZD) fortsetzen.

2. Halbleiteranordnung nach Anspruch 1, dadurch gekennzeichnet, daß die Zenerdioden (ZD) jeweils im Bereich des zum Bipolartransistor (T) benachbarten Separationsgebiet (13) angeordnet sind.

3. Halbleiteranordnung nach Anspruch 2, dadurch gekennzeichnet, daß ein Separationsgebiet (13) und eine vergrabene Schicht (12) in den Halbleiterkörper (1) eingebracht sind.

4. Halbleiteranordnung nach Anspruch 1, dadurch gekennzeichnet, daß die Zenerdioden (ZD) bei Bipolartransistoren (T) in Kollektorgrundschaltung jeweils im Bereich des Kollektoranschlußgebiets (14) des Bipolartransistors (T) angeordnet sind.

5. Verwendung einer Halbleiteranordnung nach einem der Ansprüche 1 bis 4 zur Messung der Durchbruchspannung von Zenerdioden (ZD) zumindest bei kleinen Stromstärken (I₁).

## Claims

1. Semiconductor arrangement including at least one bipolar transistor (T) and a Zener diode (ZD) which are incorporated in a common semiconductor body (1), characterised in that, a respective Zener diode (ZD), which is constructed as a measuring element, completely surrounds each bipolar transistor (T) in which increases in the electrical field strength that are detrimental to the functioning of the bipolar transistor can occur in the space charge zone of its base region (3) due to linear defects in the crystal lattice, so that the linear defects in the crystal lattice occurring in the base region (3) of this bipolar transistor (T) are extended into the semiconductor regions (8, 9) of the Zener diode (ZD).

2. Semiconductor arrangement in accordance with Claim 1, characterised in that, the Zener diodes (ZD) are each disposed in the area of the separation region (13) adjacent to the respective bipolar transistor (T).

3. Semiconductor arrangement in accordance with Claim 2, characterised in that, a separation region (13) and a buried layer (12) are incorporated into the semiconductor body (1).

4. Semiconductor arrangement in accordance with Claim 1, characterised in that, in the case of bipolar transistors (T) connected in a grounded collector configuration, the Zener diodes (ZD) are each disposed in the area of the collector terminal region (14) of the respective bipolar transistor (T).

5. The use of a semiconductor arrangement in accordance with any of the Claims 1 to 4 for measuring the breakdown voltage of Zener diodes (ZD) at least at low current levels (l₁).

## Revendications

1. Dispositif à semiconducteur équipé d'au moins un transistor bipolaire (T) et d'une diode Zener (ZD), qui sont disposés dans un substrat semiconducteur commun (1), caractérisé en ce qu'une diode Zener (ZD), qui est réalisée en tant qu'élément de mesure, entoure complètement un transistor bipolaire (T), dans lequel, dans la zone de charge d'espace de la région de base (3) peuvent apparaître des accroissements localisés de l'intensité du champ électrique altérant en raison de défauts linéaires du réseau cristallin, le mode de fonctionnement du transistor bipolaire, de sorte que les défauts linéaires du réseau cristallin se prolongent dans la région de base (3) de ce transistor bipolaire (T) dans les régions semiconductrices (8, 9) de la diode Zener (ZD).

2. Dispositif à semiconducteur selon la revendication 1, caractérisé en ce que les diodes Zener (ZD) sont disposées respectivement à proximité de la zone de séparation (13) adjacente au transistor bipolaire (T).

3. Dispositif à semiconducteur selon la revendication 2, caractérisé en ce qu'une zone de séparation (13) et une couche enterrée (12) sont disposées dans le substrat semiconducteur (1).

4. Dispositif à semiconducteur selon la revendication 1, caractérisé en ce que les diodes Zener (ZD) dans le cas de transistors bipolaires (T) en montage collecteur à la masse sont disposées respectivement à proximité de la région de borne de collecteur (14) du transistor bipolaire (T).

5. Utilisation d'un dispositif à semiconducteur selon l'une quelconque des revendications 1 à 4 en vue de la mesure de la tension de claquage de diodes Zener (ZD) au moins dans le cas de faibles intensités de courant (I₁).
